(19) Europäisches Patentamt
European Patent Office
Office européen des brevets

(11) **EP 2 005 245 B1**

(12) **FASCICULE DE BREVET EUROPEEN**

(45) Date de publication et mention de la délivrance du brevet:
**29.08.2012 Bulletin 2012/35**

(21) Numéro de dépôt: **07727615.2**

(22) Date de dépôt: **02.04.2007**

(51) Int Cl.:
**G03F 1/24** (2012.01)    **G03F 1/32** (2012.01)

(86) Numéro de dépôt international:
**PCT/EP2007/053143**

(87) Numéro de publication internationale:
**WO 2007/115961 (18.10.2007 Gazette 2007/42)**

(54) **MASQUE DE PHOTOLITHOGRAPHIE EN EXTREME ULTRA-VIOLET, AVEC COUCHE D'ARRET RESONANTE**

EXTREM-ULTRAVIOLETT-FOTOLITHOGRAPHIEMASKE MIT RESONANZBARRIERENSCHICHT

EXTREME ULTRA-VIOLET PHOTOLITHOGRAPHY MASK, WITH RESONANT BARRIER LAYER

(84) Etats contractants désignés:
**DE FR GB IT**

(30) Priorité: **07.04.2006 FR 0603108**

(43) Date de publication de la demande:
**24.12.2008 Bulletin 2008/52**

(73) Titulaire: **Commissariat à l'Énergie Atomique et aux Énergies Alternatives**
**75015 Paris (FR)**

(72) Inventeur: **CONSTANCIAS, Christophe**
**38700 Sarcenas (FR)**

(74) Mandataire: **Guérin, Michel**
**Marks & Clerk France**
**Conseils en Propriété Industrielle**
**Immeuble Visium**
**22, Avenue Aristide Briand**
**94117 Arcueil Cedex (FR)**

(56) Documents cités:
**US-A1- 2003 031 937    US-A1- 2005 084 768**

• **CHEN H L ET AL: "High reflectance of reflective-type attenuated-phase-shifting masks for extreme ultraviolet lithography with high inspection contrast in deep ultraviolet regimes" J VAC SCI TECHNOL B MICROELECTRON NANOMETER STRUCT; JOURNAL OF VACUUM SCIENCE AND TECHNOLOGY B: MICROELECTRONICS AND NANOMETER STRUCTURES NOVEMBER/DECEMBER 2004, vol. 22, no. 6, novembre 2004 (2004-11), pages 3049-3052, XP002408985**

## Description

L'invention concerne la photolithographie, et notamment la photolithographie aux très courtes longueurs d'onde. Elle concerne plus précisément une structure de masque de lithographie en extrême ultra-violet destiné à être utilisé en réflexion.

La photolithographie est utilisée pour la réalisation de microstructures électroniques, optiques, mécaniques ou des microstructures combinant des fonctions électroniques et/ou optiques et/ou mécaniques. Elle consiste à insoler par un rayonnement photonique, à travers un masque qui définit le motif souhaité, une couche de résine photosensible déposée sur un substrat plan (par exemple une tranche de silicium). Le développement chimique qui suit l'insolation révèle les motifs souhaités dans la résine. Le motif de résine ainsi gravé peut servir à plusieurs usages, le plus commun étant la gravure d'une couche sous-jacente (isolante ou conductrice ou semiconductrice) pour définir dans cette couche un motif identique à celui de la résine.

On cherche à obtenir des motifs extrêmement petits et précis et à aligner très précisément des motifs gravés dans de multiples couches superposées. Typiquement, la dimension critique des motifs souhaités est aujourd'hui d'une fraction de micromètre, voire même un dixième de micromètre et au-dessous. La longueur d'onde de la lumière utilisée dans l'opération de photolithographie limite la résolution ; plus elle est courte plus les motifs peuvent être fins. La photolithographie en ultraviolet (longueurs d'onde descendant jusqu'à 193 nanomètres) permet de faire des motifs plus fins qu'avec de la lumière visible.

On cherche aujourd'hui à descendre très largement au-dessous de ces longueurs d'onde et à travailler en extrême ultraviolet (EUV), à des longueurs d'onde comprises entre 10 et 14 nanomètres. Le but est d'obtenir une très haute résolution, malgré le fait que les ouvertures numériques disponibles en EUV soient faibles, et une profondeur de champ suffisante (supérieure à quelques centaines de nanomètres).

Mais à ces longueurs d'onde les matériaux formant le substrat du masque ne sont pas transparents et l'opération de photolithographie doit utiliser des masques fonctionnant en réflexion et non en transmission : la lumière en extrême ultraviolet est projetée sur le masque sous une faible incidence (5 à 6 degrés environ) ; le masque comporte des zones absorbantes et des zones réfléchissantes ; dans les zones réfléchissantes, le masque réfléchit la lumière sur la résine à exposer, en y imprimant son image. Le trajet de la lumière entre le masque et la résine à exposer passe par d'autres réflecteurs dont les géométries sont conçues pour projeter une image réduite du masque et non une image en grandeur réelle. La réduction d'image permet de graver sur la résine exposée des motifs plus petits que ceux qui sont gravés sur le masque.

Le masque lui-même est fabriqué à partir d'un procédé de photolithographie puis d'une gravure avec un masque de résine ou d'un masque dur (par exemple en silice, nitrure de silicium, chrome), cette fois en transmission et avec une longueur d'onde plus grande, autorisée par le fait que les motifs sont plus grands ; ou bien le masque peut être fabriqué par lithographie à faisceau d'électrons.

Typiquement, un masque en réflexion de type masque binaire est composé d'un substrat plan recouvert d'une structure réfléchissante continue, en pratique un miroir de Bragg c'est-à-dire une structure à multiples couches diélectriques d'indices de réfraction différents dont les épaisseurs sont calculées en fonction des indices, de la longueur d'onde, et de l'angle d'incidence, pour que les différentes interfaces, partiellement réfléchissantes, renvoient des ondes lumineuses en phase lés unes avec les autres ; ce miroir est recouvert d'une couche absorbante gravée selon le motif de masquage désiré, de sorte que le masque comprend des zones réfléchissantes (le miroir non recouvert d'absorbant) et des zones absorbantes (le miroir recouvert d'absorbant). A titre d'exemple, pour une longueur d'onde de 13,5 nm et un angle d'incidence de 6 degrés, on atteint théoriquement une réflectivité de 74% avec 40 couches de silicium d'épaisseur 41,5 angströms (1 angström = 0,1 nm) alternées avec 40 couches de molybdène d'épaisseur 28 angströms. Expérimentalement, on observe un écart de 5% à 10% par rapport à la réflectivité théorique. Les zones absorbantes peuvent être constituées de chrome (entre autres) déposé sur le miroir ; par exemple une couche de 600 angströms de chrome placée sur le miroir ci-dessus ne réfléchit plus que 1% de la lumière incidente.

En pratique, la couche absorbante est réalisée à l'aide de deux couches superposées sur la structure de miroir, la première étant une couche tampon et la deuxième une couche absorbante proprement dite. La couche tampon a des propriétés de sélectivité de gravure vis-à-vis de la couche absorbante, de sorte que la gravure de la deuxième couche s'arrête sur la couche tampon sans altérer le miroir ; de plus elle a des propriétés de sélectivité de gravure vis-à-vis de la structure de miroir, de sorte qu'elle peut être éliminée de la surface du miroir après gravure de la couche absorbante.

On a proposé également de réaliser les zones absorbantes en creusant localement la surface du miroir et en remplissant l'ouverture par une couche absorbante. L'effet d'ombrage est diminué, mais le procédé est très complexe. L'article "Design and Method of Fabricating Phase Shift Masks for Extreme Ultraviolet Lithography by Partial Etching into the EUV Multilayer Mirror", Sang-In Han et autres, dans Proceedings of SPIE vol 5037 (2003), décrit une telle structure.

On a proposé encore des structures de masques dits "masques EUV-PSM" (PSM pour "Phase Shift Mask", signifiant masque à déphasage en anglais). On creuse des ouvertures dans le miroir pour réduire localement son épaisseur d'une valeur telle que la lumière réfléchie dans les zones d'épaisseur réduite soit en opposition de phase avec la lumière réfléchie dans les zones d'épaisseur non réduite. Cela crée à la frontière des interférences destructrices qui constituent l'équivalent de zones absorbantes. Si le coefficient de réflexion R2 dans les zones d'épaisseur réduite reste proche du coefficient de réflexion R1 dans les zones d'épaisseur non réduite (par exemple R2 égal à 85% ou plus de R1) on parle de masque H-PSM pour "Hard PSM masks"). Si l'un des coefficients de réflexion est nettement plus faible que l'autre, on parle de masque ATT-PSM pour "Attenuated Phase Shift Mask".

Il existe aussi des masques dits Alt-PSM ou masques PSM alternés, dans lesquels deux zones réfléchissantes proches sont séparées par une zone absorbante, les deux zones réfléchissantes successives produisant des réflexions en opposition de phase, ce qui garantit le passage systématique par zéro, dans une zone absorbante, de l'intensité lumineuse réfléchie.

De même que pour les masques binaires, on peut réaliser des masques PSM en utilisant une couche tampon qui a des propriétés de sélectivité de gravure par rapport aux couches réfléchissantes qu'on doit graver.

Dans toutes ces réalisations antérieures, la couche tampon peut être gênante si elle subsiste dans les zones réfléchissantes du masque car elle ne fait que diminuer la réflectivité.

Le document US2005/084768 A1 décrit un masque EUV-PSM dont le bon rapport de réflectivité entre les deux zones réfléchissantes est obtenu en rajoutant une couche supplémentaire au dessus de la couche d'arrêt de gravure dans les zones réfléchissantes de plus faible réflectivité.

La présente invention propose de réaliser un masque à décalage de phase en donnant un rôle optique actif à la couche tampon tant en termes de choix de réflectivité qu'en termes de précision de déphasage de 180° entre zones du masque et non pas seulement un rôle de facilitateur de gravure.

Pour cela, l'invention propose de choisir l'épaisseur de cette couche tampon de telle sorte que cette couche, là où elle est située entre deux structures réfléchissantes multicouches, ait une épaisseur qui lui donne les propriétés d'une cavité résonante réfléchissante, tout en assurant un déphasage de 180° entre zones et un rapport de réflectivités désirés entre zones.

Selon l'invention, on propose un masque de photolithographie en extrême ultraviolet, fonctionnant en réflexion et du type à décalage de phase atténué, comprenant un motif gravé constitué par des premières zones réfléchissantes et des deuxièmes zones réfléchissantes, les premières zones réfléchissant la lumière avec une phase opposée à la phase de la lumière réfléchie par les deuxièmes zones, le masque comportant un substrat revêtu uniformément d'une structure réfléchissante multicouche inférieure, et, au-dessus de la structure réfléchissante inférieure, dans les premières zones, un empilement d'une couche d'arrêt de gravure et d'une structure multicouche supérieure partiellement réfléchissante, la couche d'arrêt de gravure ayant des propriétés de sélectivité de gravure par rapport aux couches de la structure réfléchissante supérieure, les deuxièmes zones réfléchissantes comprenant la structure multicouche inférieure revêtue seulement de la couche d'arrêt de gravure, et l'épaisseur de la couche d'arrêt de gravure étant choisie telle que d'une part la superposition de la structure multicouche inférieure, la couche d'arrêt de gravure, et la structure partiellement réfléchissante supérieure dans les premières zones constitue une cavité résonante de Fabry-Pérot à réflectivité variable en fonction de la longueur d'onde et présentant une forte réflectivité, supérieure à 60%, à la longueur d'onde d'utilisation du masque, d'autre part le déphasage entre les premières et deuxièmes zones réfléchissantes est proche de 180°, et le coefficient de réflexion des deuxièmes zones est largement inférieur (rapport d'environ 6 à 10%) à celui des premières zones.

Par propriétés de sélectivité de gravure, on entend ici d'abord le fait que la couche d'arrêt de gravure n'est pas ou presque pas attaquée par les produits de gravure qui permettent de graver la structure partiellement réfléchissante supérieure. On verra en effet que lors de la fabrication, après dépôt uniforme d'une structure réfléchissante supérieure, on attaque localement cette structure supérieure pour l'éliminer dans les deuxièmes zones où elle ne doit pas être présente.

Une cavité résonante de type Fabry-Pérot est constituée de deux miroirs, l'un au moins étant partiellement transparent, séparés par une certaine distance optique dans la direction de traversée de la lumière, et un espace transparent (c'est-à-dire parfaitement transparent ou peu absorbant) entre les miroirs. Par distance optique, on entend ici la somme des différentes distances optiques élémentaires dans chacun des milieux optiques successivement traversés par la lumière, chacune de ces distances optiques élémentaires étant le produit de la distance physique dans la direction de parcours de la lumière par l'indice de réfraction du milieu traversé. La cavité est résonante si la lumière directement réfléchie sur le miroir supérieur est en déphasage d'un multiple de 180° avec la lumière qui sort du miroir supérieur après un aller-retour dans la cavité incluant une réflexion sur le miroir inférieur. Si c'est un multiple impair de 180°, la cavité est absorbante en ce sens que les multiples réflexions engendrent des interférences destructives du fait qu'elles produisent des rayons en déphasage mutuel de 180° après des trajets aller-retour dans la cavité. Si c'est un multiple pair, la cavité résonante est réfléchissante, la lumière issue de multiples réflexions dans la cavité engendrant des ondes en phase avec la réflexion principale donc des interférences constructives. Cette situation de résonance peut être obtenue avec une faible distance entre miroirs (de l'ordre de 40 angströms, pour des longueurs d'onde autour de 135 angströms).

Dans ce qui suit, le mot "cavité" est pris au sens d'une cavité "optique". Les miroirs de la cavité peuvent être des structures multicouches de type miroir de Bragg.

Ainsi, le masque à déphasage comporte des premières zones qui sont réfléchissantes du fait de l'empilement d'une structure réfléchissante inférieure, d'une couche d'arrêt de gravure, et d'une structure partiellement réfléchissante supérieure, avec des propriétés de résonance de la couche d'arrêt de gravure encadrée par ces deux structures ; et le masque comporte des deuxièmes zones qui sont aussi réfléchissantes du fait de la présence de la structure réfléchissante inférieure mais qui sont moins réfléchissantes que les premières. Pour que le masque soit bien un masque à déphasage de 180°, ce qui est en général le but à atteindre, on fait en sorte que la différence de trajet optique entre les rayons réfléchis par les premières zones et les rayons réfléchis par les deuxièmes zones corresponde à un multiple impair d'une demi-longueur d'onde.

Les quantités de lumière réfléchies à la longueur d'onde d'utilisation sur chacune des zones dépendent des épaisseurs des différentes couches, de l'angle d'incidence $\theta$ de la lumière, de l'indice de propagation des matériaux traversés par la lumière (indice complexe, n, k où n est l'indice de réfraction et k le coefficient d'atténuation), et bien sûr des coefficients de réflexion et de transmission des miroirs de la cavité.

L'invention est particulièrement adaptée à réaliser des masques de type Attenuated-PSM dans lesquels la différence de coefficients de réflexion entre zones adjacentes est importante car la couche tampon peut, si elle est suffisamment épaisse, servir à ajuster cette différence de coefficients de réflexion.

L'épaisseur de la couche d'arrêt de gravure est déterminée en fonction du nombre de couches du miroir supérieur de manière que le déphasage soit bien de 180°. Cette détermination peut se faire par calcul ou par des abaques expérimentales : le déphasage dépend en effet du nombre de couches du miroir supérieur. Le nombre de couches du miroir supérieur est de préférence compris entre 9 et 20 ; trop faible il peut empêcher d'obtenir un déphasage de 180° ; trop élevé, il rendrait la couche supérieure trop peu transparente pour permettre la constitution d'une cavité résonante de Fabry-Pérot et surtout il introduirait une hauteur de marche physique trop importante entre les zones adjacentes, entraînant des effets d'ombrage indésirables. Le calcul tient compte bien entendu aussi des indices de réfraction et du cosinus de l'angle d'incidence $\theta$ de la lumière EUV en utilisation.

D'autres caractéristiques et avantages de l'invention apparaîtront à la lecture de la description détaillée qui suit et qui est faite en référence aux dessins annexés dans lesquels :

- la figure 1 représente schématiquement le principe d'une cavité résonante de type Fabry-Pérot fonctionnant en mode réflectif ;
- la figure 2 représente des courbes de réflectance, transparence, et absorption typiques d'une structure de miroir multicouche ;
- la figure 3 représente des courbes de réflectivité d'une cavité de Fabry-Pérot en fonction de la distance d séparant les deux miroirs de la cavité ;
- la figure 4 représente une structure de masque selon l'invention ;
- la figure 5 représente une structure de masque non atténué ;
- la figure 6 représente une structure de masque avec une couche d'ajustement de phase ;
- la figure 7 représente un ensemble de courbes obtenues par simulation, donnant la réflectivité, le rapport de réflectivité, et le déphasage, en fonction de l'épaisseur de la couche d'arrêt de gravure, en faisant varier le nombre de paires de couches du miroir supérieur.

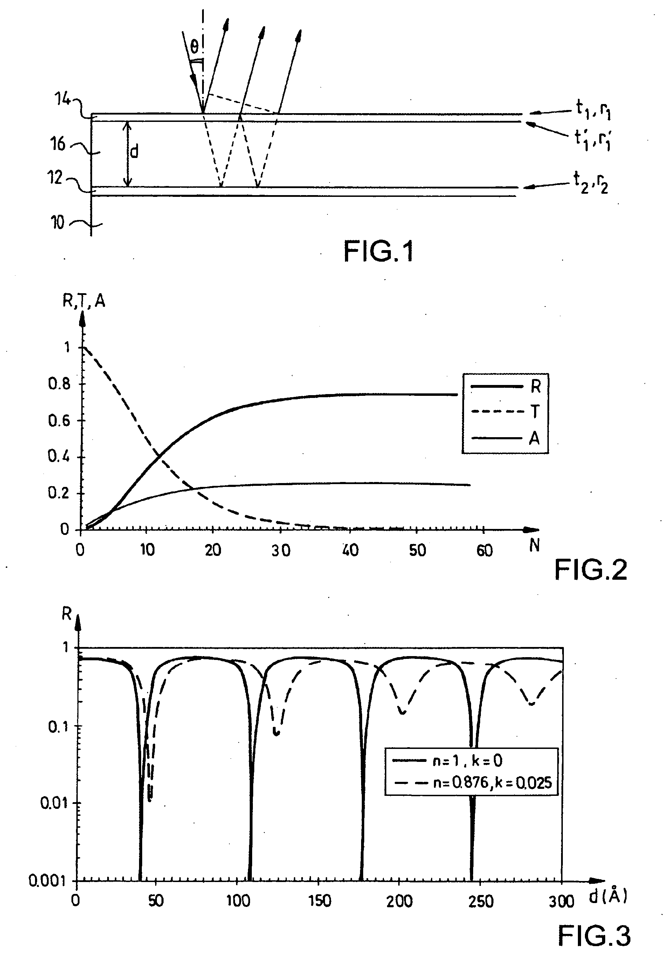

Sur la figure 1, on rappelle le principe d'une cavité résonante de Fabry-Pérot, fonctionnant en mode réflectif, le rayonnement de sortie de la cavité étant du même côté de la cavité que le rayonnement d'entrée.

On voit un substrat 10 sur lequel on a déposé un miroir inférieur supposé parfaitement réfléchissant 12, puis un miroir supérieur 14, partiellement réfléchissant et partiellement transparent, séparé du premier par une distance d, l'espace 16 entre les deux miroirs étant vide ou rempli d'un matériau transparent ou peu absorbant d'indice de réfraction n.

Les rayons lumineux incidents traversent le miroir supérieur 14 et la cavité, puis retraversent la cavité et le miroir après réflexion sur le miroir inférieur 12. La longueur du chemin optique suivi par les rayons est alors fonction de la distance d, de l'indice n, et de l'angle d'incidence $\theta$.

Le coefficient de réflexion global dépend des coefficients de transmission et de réflexion à chaque interface, à savoir t1, r1 à l'interface entre le miroir supérieur 14 et le milieu extérieur, t'1, r'1 à l'interface entre le miroir 14 et la cavité, et t2, r2 à l'interface entre la cavité et le miroir inférieur.

La cavité est résonante et absorbante si les réflexions multiples engendrent des interférences destructives, c'est-à-dire si les rayons réfléchis après un aller-retour dans la cavité sont en déphasage de 180° (un multiple impair d'une demi-longueur d'onde) avec les rayons qui sont directement réfléchis sans passer par la cavité. La condition de résonance en absorption impose alors une épaisseur d de cavité qui est :

$$d = (2m+1)\lambda/4n\cos\theta$$

m est un entier, $\lambda$ est la longueur d'onde, $\theta$ est l'angle d'incidence de la lumière.

Au contraire, la cavité est résonante et réfléchissante si les réflexions multiples engendrent des interférences constructives, c'est-à-dire si les rayons réfléchis après un aller-retour dans la cavité sont en déphasage de 360° (un multiple pair d'une demi-longueur d'onde) avec les rayons qui sont directement réfléchis sans passer par la cavité. La condition de résonance en réflexion impose alors une épaisseur d de cavité qui est :

$$d = 2m\lambda/4n\cos\theta$$

Des courbes de réflectivité en fonction de l'épaisseur à longueur d'onde fixée ou de longueur d'onde d'utilisation à épaisseur fixée présentent alors des pics de réflectivité et des pics d'absorption alternés représentant la résonance en réflexion et la résonance en absorption respectivement.

Ces valeurs de condition de résonance sont des valeurs théoriques, les valeurs expérimentales pouvant être légèrement différentes, sans que le principe reste changé, en fonction notamment de la constitution des miroirs. En particulier, les miroirs peuvent être constitués par des structures multicouches de Bragg et les conditions pour obtenir la résonance doivent en tenir compte car on ne peut pas considérer que la réflexion dans un miroir multicouche se produit exactement à la surface de la couche supérieure. Pour simplifier les explications on supposera quand même que la distance entre les miroirs est régie par les formules ci-dessus pour obtenir la résonance.

La réflectivité et la transparence des structures multicouches dépendent du nombre de couches. La figure 2 représente à titre d'exemple les courbes de réflectivité et de transparence de structures à couches de silicium (41,5 angstrôms) et de molybdène (28 angstrôms) alternés pour une longueur d'onde de 13,5 nanomètres (préférée selon l'invention) et un angle d'incidence de 6°, en fonction du nombre N de paires de couches. La réflectivité R, la transparence T et l'absorption A sont représentées. On constate que la réflectivité et la transparence sont à peu près égales pour N=12 paires de couches ; on peut réaliser le miroir supérieur 14 avec 12 paires de couches si on veut qu'il soit réfléchissant à 50%.

Dans la suite, les données numériques seront fondées sur un choix de 13,5 nanomètres pour la longueur d'onde et 6° pour l'angle d'incidence.

La figure 3 représente la réflectivité R de l'ensemble de la cavité de Fabry-Pérot, en fonction de la distance d, lorsque la cavité est réalisée avec un miroir supérieur semi-transparent à 12 paires de couches Si(41,5 angstrôms)Mo (28 angstrôms), et avec un miroir inférieur à 30 paires de couches (mêmes épaisseurs). Ces miroirs sont des miroirs de Bragg et les épaisseurs 41,5 et 28 angstrôms sont des épaisseurs qui correspondent à des déphasages optiques multiples d'une demi-longueur d'onde en tenant compte des indices optiques différents des deux matériaux, et en tenant compte de l'angle d'incidence prévu (6°), afin que les couches multiples jouent le rôle de miroir en établissant des réflexions multiples toutes en phase à la sortie du miroir.

Sur la figure 3 on a représenté deux courbes :

- l'une en traits pleins avec une cavité vide ou remplie d'air (indice 1, atténuation 0) ;
- l'autre en traits tiretés avec une cavité supposée remplie d'un matériau peu absorbant supposé avoir un indice de propagation n=0,876, k=0,025.

On constate que la structure de la figure 1 présente des pics d'absorption (réflexion très faible) pour certaines valeurs de la distance d et qu'au contraire la réflectivité est maximale autour du milieu de l'intervalle entre ces pics. On constaterait des pics de réflectivité si on traçait les courbes en fonction de la longueur d'onde pour une épaisseur d donnée.

La position du point de réflectivité maximale dépend de l'indice du matériau transparent situé entre les miroirs.

Les pics de réflectivité sont relativement aplatis, ce qui montre qu'on peut faire varier assez largement l'épaisseur de la cavité tout en gardant une réflectivité importante.

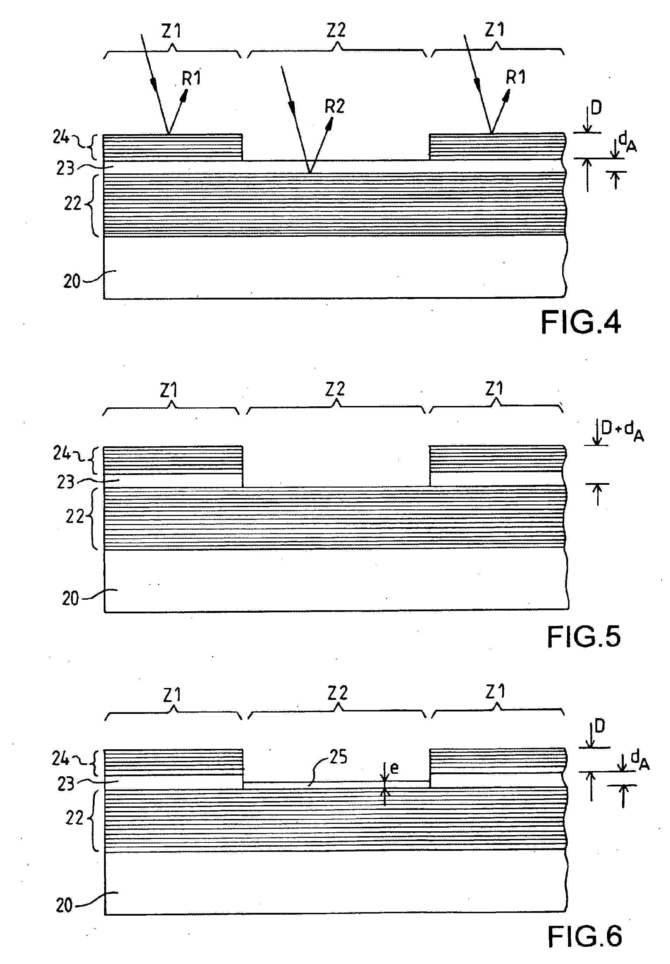

Partant de ces observations, on constitue un masque EUV en réflexion, à déphasage (PSM) dont la réalisation est schématisée à la figure 4.

Le masque est formé sur un substrat 20 à surface plane, et il comprend des zones Z1 d'un premier type et des zones Z2 d'un second type. Les zones Z1 réfléchissent la lumière ultraviolette incidente avec un coefficient de réflexion R1, et les zones Z2 réfléchissent la lumière avec un coefficient de réflexion R2 et un déphasage multiple impair de 180° par rapport à la phase de la lumière réfléchie par les zones Z1.

Les zones Z1 sont constituées par l'empilement d'une structure réfléchissante multicouches inférieure 22, d'une couche d'arrêt de gravure 23, et d'une structure multicouches partiellement réfléchissante supérieure 24. Les zones Z2 sont constituées par l'empilement de la même structure réfléchissante inférieure 22 et la même couche d'arrêt de gravure 23, mais elles ne comportent pas de structure supérieure 24 ni d'autre couche au-dessus de la couche d'arrêt de gravure (sauf éventuellement une ou plusieurs couches de protection qui recouvriraient à la fois les zones Z1 et Z2).

La structure multicouche inférieure 22 est constituée par exemple par au moins 30 paires de couches alternées de silicium (41,5 angströms d'épaisseur) et de molybdène (28 angstrôms d'épaisseur). Ces valeurs numériques sont liées au choix d'une longueur d'onde d'utilisation préférée de 13,5 nanomètres et d'un angle d'incidence préféré en utilisation d'environ 6° qu'on adopte pour tous les exemples donnés dans cette description. Avec une autre longueur d'onde et un autre angle d'incidence, il faudrait choisir d'autres valeurs pour respecter la condition de Bragg et obtenir des miroirs réfléchissants.

D'une façon générale, l'homme du métier déterminera les épaisseurs des couches de l'empilement en utilisant la loi de Bragg.

La structure supérieure peut être constituée par exemple par des paires de couches identiques Si (41,5 angstrôms)/Mo(28 angstrôms) mais en nombre plus réduit, par exemple entre 9 et 15 paires de couches ; ce nombre réduit est dû au fait qu'on souhaite limiter la différence de hauteur entre ta surface supérieure des zones Z1 et la surface supérieure des zones Z2 pour ne pas engendrer d'effet d'ombrage trop important en présence d'une illumination sous incidence oblique ; un nombre réduit de couches engendre une réflectivité inférieure et c'est pourquoi la structure multicouche 24 est qualifiée de partiellement réfléchissante. La structure multicouche supérieure n'est pas obligatoirement constituée de couches identiques à celles de la structure inférieure.

La raison de la présence de la couche d'arrêt de gravure 23 tient au procédé de fabrication : le dépôt de la structure multicouche supérieure 24 est fait uniformément sur tout le substrat 20, au-dessus de la structure inférieure et les zones Z2 sont définies par photolithographie et enlèvement local de la structure supérieure 24 qui ne subsiste que dans les zones Z1. Pour définir précisément le nombre de couches ou de paires de couches enlevées dans les zones Z2 et pour éviter d'endommager la surface supérieure de la structure 22 dans ces zones, on interpose la couche 23 entre les deux structures 22 et 24. La couche d'arrêt de gravure 23 n'est pas attaquée par les produits de gravure de la structure multicouches 24. On peut donc enlever toute l'épaisseur de structure supérieure 24 sans difficulté dans les zones Z2 et la structure inférieure reste complètement protégée lors de cette gravure.

On comprend que si la couche d'arrêt 23 n'était pas présente, le coefficient de réflexion dans les zones Z1 serait très élevé car il résulte de la superposition d'un nombre élevé de paires de couches dont les épaisseurs satisfont la condition de résonance de Bragg.

Mais la présence de la couche d'arrêt perturbe cette réflectivité, et de plus elle introduit un déphasage entre zones qui varie non linéairement avec l'épaisseur de la couche.

On peut s'arranger notamment pour que la couche d'arrêt 23, choisie suffisamment transparente, satisfasse aussi à peu près la condition de Bragg et établisse un déphasage optique multiple autour de 180° pour les rayons qui la traversent, afin que l'aller-retour de rayons à travers cette couche établisse un déphasage multiple autour de 360°. Cette couche transparente, placée entre un miroir partiellement réfléchissant (structure 24) et un miroir réfléchissant (structure 22) constitue alors, à la longueur d'onde d'utilisation et pour l'incidence choisie, une cavité résonante réfléchissante de Fabry-Pérot présentant un maximum de réflectivité ou tout au moins une forte réflectivité. On verra qu'on ne se situe pas nécessairement au sommet de la courbe de réflectivité en fonction de l'épaisseur (ou de la longueur d'onde) en raison des autres contraintes qui pèsent selon l'invention sur le choix d'épaisseurs de la couche d'arrêt de gravure.

Dans les zones Z2, la réflectivité est plus faible; voire même beaucoup plus faible pour un masque Attenuated-PSM ; l'épaisseur de la couche 23 reste la même que dans les zones Z1 (ou presque la même si on tient compte du fait que la gravure du miroir supérieur peut attaquer très légèrement la couche d'arrêt de gravure). La raison pour laquelle on conserve cette épaisseur est la suivante : on souhaite industriellement minimiser le nombre d'étapes de fabrication et on préfère donc ne pas introduire une étape d'enlèvement ou une étape de rajout de couche ; mais on comprend qu'alors les contraintes qui pèsent sur le choix de l'épaisseur s'accroissent car on veut que cette épaisseur réponde non seulement à la condition de réflectivité élevée dans les zones Z1 mais aussi à une condition de déphasage entre zones Z1 et Z2 et à une condition d'atténuation désirée, plus forte dans les zones Z2 que dans les zones Z1.

Contrairement à ce qui a été proposé dans l'art antérieur, on a trouvé selon l'invention qu'il était possible de satisfaire à ces multiples conditions, ceci notamment parce que les conditions de réflectivité élevée de la cavité de Fabry Pérot dans les zones Z1 peuvent être satisfaites même avec une large gamme d'épaisseurs de couche d'arrêt de gravure.

En choisissant une épaisseur de couche d'arrêt de gravure suffisamment élevée, on peut obtenir une atténuation beaucoup plus élevée dans les zones Z2 que dans les zones Z1. Mais comme les conditions de Fabry-Pérot sont périodiques (cf figure 3), on peut les obtenir même avec des épaisseurs importantes.

On ajuste l'épaisseur de la couche d'arrêt de gravure pour obtenir, la condition de déphasage de 180° entre zones Z1 et zones Z2. Ceci peut se faire par des abaques qui prennent en compte toute la structure des zones Z1 et Z2. On a remarqué qu'en pratique on peut toujours trouver une épaisseur qui d'une part correspond à une absorption suffisante dans les zones Z2 (mais le coefficient de réflexion n'a pas besoin d'être précis : il peut par exemple se situer entre 6 et 10% du coefficient de réflexion des zones Z1) et d'autre part satisfait à la condition de déphasage de 180° entre zones Z1 et zones Z2, tout en restant dans la zone supérieure (assez aplatie) des pics de réflectivité de la cavité de Fabry-Pérot des zones Z1.

Dans l'art antérieur, on considérait plutôt qu'il fallait enlever la couche d'arrêt de gravure dans les zones Z1 (pour faire des masques hard-PSM) ou rajouter des couches spécifiquement absorbantes. Selon l'invention, on a trouvé que, malgré la triple contrainte des réflectivités, des déphasages, et de l'atténuation, on pouvait simplifier grandement les processus de fabrication industrielle d'un masque PSM atténué en conservant la couche d'arrêt de gravure telle quelle, sans enlèvement ni rajout d'autre couche.

La couche d'arrêt de gravure 23 peut être en oxyde de silicium ; on sait graver sélectivement le silicium ou le molybdène par rapport à l'oxyde de silicium. Le chrome peut aussi convenir, d'autant plus que son utilisation industrielle est bien maîtrisée. D'autres matériaux sont possibles, et notamment les suivants : $Ru$, $ZrO_2$, $Ti$, $TiN$, $Al$, $HfO_2$, $Hf$, $Ta$, $W$, $TaN$. Ces matériaux sont cités dans l'ordre du moins absorbant au plus absorbant (à la longueur d'onde de 13,5 nanomètres), leur coefficient d'atténuation k pouvant varier de k=0,01 à k=0,045.

Le déphasage optique introduit entre les zones Z1 et Z2 est lié à la hauteur D de la structure multicouche supérieure 24, à la nature des couches de cette structure, au nombre de ces couches, et à la hauteur $d_A$ et à l'indice $n_A$ de la couche d'arrêt 23.

Le calcul du déphasage entre les zones Z1 et Z2 est un calcul complexe, en général fait par des programmes informatiques spécifiques tels que le logiciel gratuit IMD disponible sur le site internet http://www.esrf.fr/computing/scientific/xop/extensions.html.

On rappelle les bases de calculs : l'existence d'une cavité résonante dans la zone Z1 introduit une variation de phase entre les zones Z1 et Z2 et cette variation est non linéaire avec la hauteur D+d a de la couche d'arrêt. L'amplitude complexe $AR_1$ de l'onde réfléchie au sommet des couches dans la zone Z1 est

$$AR_1 = [R_1+(R_1{}^2+T_1).R_2\exp(j\Phi)]/[1+R_1R_2.\exp(j\Phi)]$$

avec

$$\Phi = (2\pi/\lambda)2n_A.d.\cos\theta$$

$R_1$ est le coefficient de réflexion global du miroir supérieur, $R_2$ celui du miroir inférieur, $T_1$ la transparence du miroir supérieur, $n_A$ l'indice de la couche tampon.

Les coefficients des miroirs se calculent par itération selon les lois connues de Fresnel : typiquement le coefficient de réflexion de l'empilement de j couches se calcule à partir du coefficient de réflexion théorique rj,j-1 de l'interface entre la couche j et la couche j-1 immédiatement inférieure et du coefficient de réflexion global $r_{j-1}$ de l'empilement des j-1 couches sous-jacentes ; il fait intervenir aussi le déphasage introduit par la $j^{\text{ème}}$ couche, à savoir $\Phi_j = (2\pi dn_j\cos\theta)/\lambda$ où $n_j$ est l'indice de la couche de rang j.

$$r_j = [r_{j,j-1} + r_{j-1} \exp2i\Phi_i]/[1 + r_{j,j-1}r_{j-1}\exp2i\Phi_j]$$

Le calcul est très semblable pour le coefficient de transmission $t_j$ de l'empilement de j couches, qui se fait également par itération des coefficients de transmission $t_{j,j-1}$ de l'interface entre la couche j et la couche j-1 et du coefficient de transmission global $t_{j-1}$ de l'empilement de j-1 couches sous-jacentes :

$$t_j = [t_{j,j-1}t_{j-1} \exp2i\Phi_i]/[1 + r_{j,j-1}r_{j-1}\exp2i\Phi_j]$$

Les coefficients $r_{j,j-1}$ et $t_{j,j-1}$ sont calculés par les équations de Fresnel définissant la réflexion et la transmission entre deux couches d'indices différents.

On comprend que ces différents paramètres définissent plusieurs degrés de liberté pour le choix d'épaisseurs de couches conduisant à un certain coefficient de réflexion dans chacune des zones Z1 et Z2 et un certain déphasage entre les ondes réfléchies dans ces deux zones.

Entrent en ligne de compte pour ces choix :

- la constitution du miroir inférieur, nombre de paires de couches, épaisseur de la paire, choix des couches et de leurs rapports d'épaisseurs,
- même chose pour le miroir supérieur,
- nombre de paires de couches à graver pour obtenir un déphasage de 180 ° .
- le matériau de la couche d'arrêt (son indice $n_A$ notamment)
- l'épaisseur $d_A$ de cette couche d'arrêt.

On sait tracer expérimentalement des courbes de déphasage et de réflectivité en fonction de l'épaisseur de la couche d'arrêt pour différents nombres de paires de couches du miroir supérieur.

Dans un exemple de telles mesures expérimentales, faites avec de la silice comme couche d'arrêt de gravure, et avec des paires de couches molybdène, silicium ayant les épaisses définies précédemment qu'on pouvait obtenir un déphasage de 180° à condition d'avoir au moins 9 paires de couches Mo/Si mais de préférence de 11 à 17 (au delà, l'épaisseur du miroir supérieur entraînerait des effets d'ombrage préjudiciables pour l'incidence de 6° envisagée dans cet exemple.

Typiquement, avec les valeurs numériques envisagées précédemment, on peut réaliser un masque Hard PSM avec 9 paires de couches du miroir supérieur et une épaisseur de silice de 32 angströms ou 100 angströms comme couche d'arrêt de gravure. Le déphasage est de 180° et le rapport, de réflectivité entre les zones Z2 et les zones Z1 sur lesquelles subsiste la couche de silice. Si le nombre de paires de couches du miroir supérieur est 11, l'épaisseur de silice est de 20 angstrôms pour obtenir un déphasage de 180°. Le rapport de réflectivités est supérieur à 90%.

Si maintenant on enlève la couche d'arrêt de gravure dans la zone Z2, on peut avoir 11 paires de couches sur le miroir supérieur et une épaisseur de 90 angströms de couche d'arrêt de silice ; le rapport de réflectivités reste proche de 1 : de l'ordre de 85%.

Mais on peut également obtenir grâce à la présence de la cavité résonante de Fabry-Pérot constituée par la couche de silice entre les deux miroirs, un rapport de réflectivités beaucoup plus faible, de l'ordre de 10% par exemple ou 6%, en conservant la couche d'arrêt dans les zones Z2 et en l'utilisant comme couche absorbante, avec toujours un calcul d'épaisseur donnant un déphasage de 180 ° entre les zones Z1 et Z2.

Une fois le matériau de la couche d'arrêt choisi, on fixe à la fois le nombre de paires de couches de molybdène et de silicium constituant le miroir supérieur 24 dans les zones Z1 et l'épaisseur de la couche d'arrêt de gravure. Le déphasage varie en fonction de cette épaisseur pour un nombre de paires donné. Cette variation est en dent de scie et un déphasage de 180° peut être obtenu pour une série discrètes d'épaisseurs, pour un nombre de paires donné.

Le rapport de réflectivités entre les zones Z1 et Z2 varie aussi beaucoup en fonction de l'épaisseur de la couche d'arrêt de gravure.

Il est possible de tracer par simulation des courbes de variation du rapport de réflectivités et du déphasage, à chaque fois en fonction de l'épaisseur de couche d'arrêt et du nombre de paires de couches du miroir. Et à partir de là on peut trouver des couples épaisseur de couche d'arrêt/nombre de paires du miroir qui donnent le résultat recherché, à savoir à la fois un déphasage de 180°, une bonne réflectivité de la zone Z2 et un rapport de réflectivités désiré entre les zones Z2 et les zones Z1 (typiquement 6 à 10%).

S'il y a plusieurs choix possibles pour les nombres de paires de couches de la zone Z1, on prend le plus petit nombre de paires, pour minimiser les effets d'ombrage.

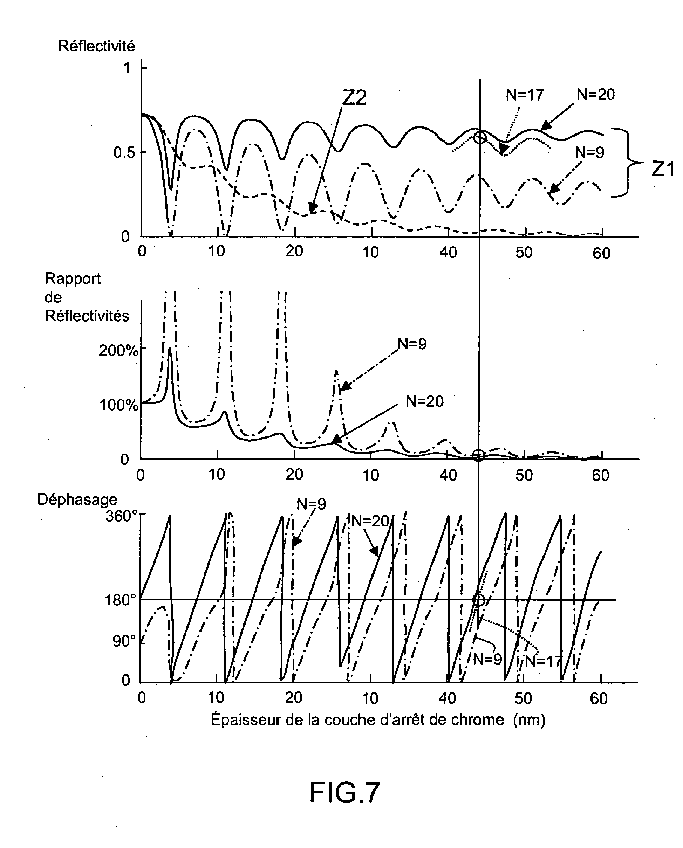

Sur la figure 7, on a donné à titre d'exemple un ensemble de courbes obtenues par simulation, pour faire comprendre comment on peut choisir les conditions d'obtention désirées. Toutes les courbes sont tracées en fonction de l'épaisseur de la couche d'arrêt de gravure, en nanomètres. La couche est en chrome.

Les courbes de la partie supérieure sont des courbes de réflectivité. La courbe en ligne tiretée simple est la courbe de réflectivité de la zone Z2, globalement décroissante en raison du coefficient d'absorption du chrome. La courbe en trait plein est la courbe de réflectivité de la zone Z1 lorsqu'il y a N=20 paires de couches de molybdène et de silicium dans le miroir supérieur. La courbe en ligne mixte (traits et points) est la courbe de réflectivité de la zone Z1 lorsqu'il y a N=9 paires de couches dans le miroir supérieur.

Entre les courbes représentant la réflectivité de la zone Z1, on n'a pas représenté les courbes pour des nombres de paires de couches comprises entre 9 et 20, pour conserver une lisibilité suffisante du diagramme. Toutefois on a représenté en ligne pointillée serrée une petite portion de la courbe correspondant à N=17 paires de couches dans le miroir supérieur.

Les courbes de la partie centrale de la figure 7 sont tirées des courbes de la partie supérieure et représentent les rapports de réflectivité entre la zone Z1 et la zone Z2, en fonction de l'épaisseur de la couche d'arrêt de gravure et pour chaque nombre N de paires de couches du miroir supérieur. Seules les courbes pour N=9 (ligne mixte points-traits) et pour N=20 (trait plein) sont représentées. Les courbes pour d'autres valeurs de N sont intermédiaires.

Les courbes de la partie inférieure de la figure 7 représentent le déphasage entre les zones Z1 et les zones Z2. Le déphasage est représenté modulo 360° et il varie donc en dents de scie et dépend du nombre N de paires de couches. Les courbes sont représentées pour N=9 (ligne mixte), pour N=20 (trait plein), et une petite portion est représentée (ligne pointillée) pour N=17.

En observant ces couches on constate qu'on peut trouver un choix d'épaisseur et de nombre de paires de couches qui fournit un déphasage de 180°, une forte réflectivité de la zone Z2 (supérieure à 60%) et un rapport de réflectivité désiré entre zone Z1 et zone Z2. On a représenté sur la figure 7 à titre d'exemple un point de fonctionnement souhaité pour un rapport de réflectivité d'environ 6 à 10%. Ce point est trouvé pour N=17 paires de couches et pour une épaisseur de couche d'arrêt de chrome d'environ 44 nanomètres.

Si plusieurs points sont possibles, on choisira celui qui minimise le nombre de paires de couches du miroir supérieur.

L'invention est particulièrement intéressante pour réaliser des masques à décalage de phase atténués.

La réalisation industrielle est plus facile que si on utilisait, comme dans le cas de la figure 6, une couche spécifique d'ajustement de phase. Dans le cas de la figure 6, on commence par éliminer la couche 23 dans les zones Z2 comme dans la figure 5, puis on dépose une couche supplémentaire de matériau transparent 25 sur les zones Z2. La couche 25 peut être identique en matériau (oxyde de silicium par exemple) à la couche 23, mais elle n'a pas la même épaisseur $d_A$. Cette couche 25 a une épaisseur contrôlée e qui sert à ajuster finement le déphasage de 180° introduit par la différence de marche entre la surface supérieure des zones Z1 et la surface supérieure des zones Z2. On pourrait théoriquement ajuster le déphasage en enlevant une partie seulement de l'épaisseur de la couche d'arrêt 23, dans une réalisation qui serait intermédiaire entre celles des figures 5 et 6 ; cependant, le contrôle des épaisseurs enlevées par attaque chimique n'est pas très précis et on préfère enlever la totalité de la couche d'arrêt 23 dans les zones Z2 et déposer à nouveau une épaisseur contrôlée d'un matériau transparent, car le contrôle de l'épaisseur dans une phase de dépôt est beaucoup plus précis que le contrôle de l'épaisseur dans une phase d'enlèvement de matière.

L'épaisseur e rajoutée pour que le déphasage entre les zones Z1 et Z2 soit aussi proche que possible de 180° (ou un multiple impair de 180°) peut se calculer en fonction des paramètres suivants : l'angle d'incidence θ, l'indice optique (en ultraviolet) de la couche 25, la hauteur D de la structure 22 enlevée, la hauteur $d_A$ de la couche d'arrêt enlevée.

Le choix de l'épaisseur rajoutée dépend de l'indice de réfraction $n_B$ de la couche 25.

On peut donc choisir finement l'épaisseur e qui produit un déphasage de 180 ° ou multiple impair de 180 °.

On pourrait envisager aussi une couche d'ajustement de déphasage en un matériau transparent tel que le silicium (dans le cas d'un masque Hard-PSM).

Pour déposer la couche d'ajustement 25, on peut utiliser un procédé dit de lift-off : dépôt d'une résine, photogravure pour l'enlever dans les zones Z2, dépôt de la couche d'ajustement 25, et enlèvement de la résine avec la couche qui la recouvre, seules les zones dépourvues de résine conservant la couche d'ajustement.

On pourrait également déposer une couche d'ajustement de phase sur la couche d'arrêt de gravure sans la retirer.

Comme on le voit, cette solution de la figure 6 est dans tous les cas plus complexe que celle de la figure 4 qui consiste à conserver purement et simplement la couche d'arrêt de gravure dont l'épaisseur aura été choisie dès le départ pour tenir compte des trois contraintes de réflectivité des zones Z1, rapport de réflectivité entre zones Z1 et zones Z2, et déphasage de 180° entre les zones Z1 et les zones Z2.

L'invention est applicable aux masques PSM atténués .

## Revendications

**1.** Masque de photolithographie en extrême ultraviolet, fonctionnant en réflexion et du type à décalage de phase atténué, comprenant un motif gravé constitué par des premières zones réfléchissantes (Z1) et des deuxièmes zones réfléchissantes (Z2), les premières zones réfléchissant la lumière avec une phase opposée à la phase de la lumière réfléchie par les deuxièmes zones, le masque comportant un substrat (20) revêtu uniformément d'une structure réfléchissante multicouche inférieure (22), et, au-dessus de la structure réfléchissante inférieure, dans les premières zones, un empilement d'une couche d'arrêt de gravure (23) et d'une structure multicouche supérieure partiellement réfléchissante (24), la couche d'arrêt de gravure ayant des propriétés de sélectivité de gravure par rapport aux couches de la structure réfléchissante supérieure, les deuxièmes zones réfléchissantes comprenant la structure multicouche inférieure revêtue seulement de la couche d'arrêt de gravure, l'épaisseur ($d_A$) de la couche d'arrêt de gravure étant choisie telle que d'une part la superposition de la structure multicouche inférieure (22), la couche d'arrêt de gravure (23), et la structure partiellement réfléchissante supérieure (24) dans les premières zones (Z1) constitue une cavité résonante de Fabry-Pérot, à réflectivité variable en fonction de la longueur d'onde et présentant une forte réflectivité à la longueur d'onde d'utilisation du masque, d'autre part le déphasage entre les premières et deuxièmes zones réfléchissantes est proche de 180°, et le coefficient de réflexion des deuxièmes zones est largement inférieur à celui des premières zones , **caractérisé en ce que** la réflectivité des premières zones est supérieure à 60%, et le rapport de réflectivités entre les deuxième zones et les premières est d'environ 6 à 10%.

**2.** Masque selon la revendication 1, **caractérisé en ce que** l'épaisseur de la couche d'arrêt de gravure (23) est la même dans les premières et deuxièmes zones

**3.** Masque selon l'une des revendications 1 et 2, **caractérisé en ce que** la couche d'arrêt de gravure est en chrome.

**4.** Masque selon l'une des revendications 1 et 2, **caractérisé en ce que** la couche d'arrêt de gravure est en oxyde de silicium.

**5.** Masque selon l'une des revendications 1 et 2, **caractérisé en ce que** la couche d'arrêt de gravure est choisie parmi les matériaux suivants : Ru, $ZrO_2$, Ti, TiN, Al, $HfO_2$, Hf, Ta, W, TaN.

**6.** Masque selon l'une des revendications précédentes, **caractérisé en ce que** sa longueur d'onde d'utilisation est 13,5 nanomètres.

## Claims

**1.** An extreme ultraviolet photolithography mask, operating in reflection and of the attenuated phase shift type, comprising an etched pattern made up of first reflecting zones (Z1) and second reflecting zones (Z2), the first zones reflecting the light with a phase opposite the phase of the light reflected by the second zones, the mask comprising a substrate (20) uniformly coated with a multilayer lower reflective structure (22) and on top of the lower reflective structure, in the first zones, a stack of an etch stop layer (23) and of a partially reflective upper multilayer structure (24), the etch stop layer having etch selectivity properties relative to the layers of the upper reflective structure, the second reflecting zones comprising the lower multilayer structure coated only with the etch stop layer, the thickness ($d_A$) of the etch stop layer being chosen so that, on the one hand, the superposition of the lower multilayer structure (22), the etch stop layer (23) and the partially reflective upper structure (24) in the first zones (Z1) constitutes a Fabry-Pérot resonant cavity having reflectivity that varies as a function of the wavelength and having a high reflectivity at the operating wavelength of the mask and, on the other hand, the phase shift between the first and second reflecting zones is close to 180°, and the reflection coefficient of the second zones is considerably lower than that of the first zones, **characterized in that** the reflectivity of the first zones is greater than 60%, and the ratio of reflectivities between the second zones and the first is around 6 to 10%.

**2.** Mask according to claim 1, **characterized in that** the thickness of the etch-stop layer (23) is the same in the first and second zones.

**3.** The mask as claimed in either of claims 1 and 2, **characterized in that** the etch stop layer is made of chromium.

**4.** The mask as claimed in either of claims 1 and 2, **characterized in that** the etch stop layer is made of silicon oxide.

**5.** The mask as claimed in either of claims 1 and 2, **characterized in that** the etch stop layer is chosen from the following materials: Ru, $ZrO_2$, Ti, TiN, Al, $HfO_2$, Hf, Ta, W, TaN.

**6.** The mask as claimed in one of the preceding claims, **characterized in that** its operating wavelength is 13.5 nanometers.

## Patentansprüche

**1.** Fotolithografiemaske im extrem ultravioletten Bereich, die durch Reflexion arbeitet und vom Typ mit gedämpfter Phasenverschiebung ist, umfassend ein geätztes Muster, das von ersten reflektierenden Zonen (Z1) und zweiten reflektierenden Zonen (Z2) gebildet wird, wobei die ersten Zonen das Licht mit einer Phase reflektieren, die der Phase des Lichts entgegengesetzt ist, das von den zweiten Zonen reflektiert wird, wobei die Maske ein Substrat (20), das gleichförmig mit einer mehrschichtigen unteren reflektierenden Struktur (22) überzogen ist, und über der unteren reflektierenden Struktur, in den ersten Zonen, einen Stapel aus einer Ätzstoppschicht (23) und einer mehrschichtigen teilreflektierenden oberen Struktur (24) umfasst, wobei die Ätzstoppschicht Ätzselektivitätseigenschaften in Bezug auf die Schichten der oberen reflektierenden Struktur aufweist, wobei die zweiten reflektierenden Zonen die untere mehrschichtige Struktur nur mit der Ätzstoppschicht überzogen umfassen, wobei die Dicke ($d_A$) der Ätzstoppschicht so gewählt wird, dass einerseits die Übereinanderschichtung der unteren mehrschichtigen Struktur (22), der Ätzstoppschicht (23) und der teilreflektierenden oberen Struktur (24) in den ersten Zonen (Z1) einen Fabry-Pérot-Resonanzhohlraum bildet, mit veränderlichem Reflexionsgrad in Abhängigkeit von der Wellenlänge und mit einem hohen Reflexionsgrad bei der Nutzwellenlänge der Maske, und dass andererseits die Phasenverschiebung zwischen den ersten und zweiten reflektierenden Zonen nahe 180° liegt und der Reflexionskoeffizient der zweiten Zonen weitaus kleiner ist als der der ersten Zonen, **dadurch gekennzeichnet, dass** der Reflexionsgrad der ersten Zonen höher als 60 % ist und das Verhältnis zwischen den Reflexionsgraden zwischen den zweiten Zonen und den ersten Zonen bei etwa 6 bis 10 % liegt.

2. Maske nach Anspruch 1, **dadurch gekennzeichnet, dass** die Dicke der Ätzstoppschicht (23) in den ersten und zweiten Zonen gleich ist.

3. Maske nach einem der Ansprüche 1 und 2, **dadurch gekennzeichnet, dass** die Ätzstoppschicht aus Chrom ist.

4. Maske nach einem der Ansprüche 1 und 2, **dadurch gekennzeichnet, dass** die Ätzstoppschicht aus Siliciumoxid ist.

5. Maske nach einem der Ansprüche 1 und 2, **dadurch gekennzeichnet, dass** die Ätzstoppschicht aus den folgenden Materialien ausgewählt ist: Ru, $ZrO_2$, Ti, TiN, Al, $HfO_2$, Hf, Ta, W, TaN.

6. Maske nach einem der vorherigen Ansprüche, **dadurch gekennzeichnet, dass** die Nutzwellenlänge 13,5 Nanometer beträgt.

FIG.1

FIG.2

FIG.3

FIG.4

FIG.5

FIG.6

FIG.7

## RÉFÉRENCES CITÉES DANS LA DESCRIPTION

*Cette liste de références citées par le demandeur vise uniquement à aider le lecteur et ne fait pas partie du document de brevet européen. Même si le plus grand soin a été accordé à sa conception, des erreurs ou des omissions ne peuvent être exclues et l'OEB décline toute responsabilité à cet égard.*

**Documents brevets cités dans la description**

- US 2005084768 A1

**Littérature non-brevet citée dans la description**

- **SANG-IN HAN.** Design and Method of Fabricating Phase Shift Masks for Extreme Ultraviolet Lithography by Partial Etching into the EUV Multilayer Mirror. *Proceedings of SPIE,* 2003, vol. 5037